Europäisches Patentamt

European Patent Office

Office européen des brevets

(11) Publication number:
**0 292 235**
**A2**

# EUROPEAN PATENT APPLICATION

(21) Application number: 88304450.5

(22) Date of filing: 17.05.88

(51) Int. Cl.⁴: **H01L 21/00**

(30) Priority: 18.05.87 US 51536

(43) Date of publication of application:
**23.11.88 Bulletin 88/47**

(84) Designated Contracting States:
**DE GB NL**

(71) Applicant: **ASYST TECHNOLOGIES**
**1745 McCanless Drive**
**Milpitas, CA 95035(US)**

(72) Inventor: **Bonora, Anthony Charles**
**300 Felton Drive**
**Menlo Park California 94025(US)**
Inventor: **Rosenquist, Fred T.**
**738 Canyon Road**
**Redwood City California 94062(US)**

(74) Representative: **Crawford, Andrew Birkby et al**
**A.A. THORNTON & CO. Northumberland**
**House 303-306 High Holborn**
**London WC1V 7LE(GB)**

(54) Manipulator apparatus with linear drive for sealed standard mechanical interface apparatus.

(57) An apparatus for transferring a cassette holding articles to be processed to and from a container supported at a processing station where the processing station has a cassette port for receiving the cassette when the cassette moves along a central axis extending from outside the processing station through the cassette port, and into the processing station, the apparatus comprising: a cassette platform including a cassette platform transportable along the vertical axis for transferring the cassette to and from the container along the axis; a mechanical manipulator including an arm pivotably attached to a platform for engaging the cassette and for transferring the cassette to a location offset from the axis; and a device for linear translation of the platform and arm in a direction substantially displaced from the axis.

FIG. —1

# MANIPULATOR APPARATUS WITH LINEAR DRIVE FOR SEALED STANDARD MECHANICAL INTERFACE APPARATUS

## FIELD OF THE INVENTION

The present invention relates to manipulating apparatus for standardized mechanical interface systems for reducing particle contamination and more particularly to apparatus transferring cassettes containing articles to be processed into and out of sealed containers suitable for use in semiconductor processing equipment to prevent particle contamination.

A standardized mechanical interface (SMIF) has been proposed to reduce particle contamination by significantly reducing particle fluxes onto wafers. This end is accomplished by mechanically ensuring that during transport, storage and processing of the wafers, the gaseous media (such as air or nitrogen) surrounding the wafers is essentially stationary relative to the wafers and by ensuring that particles from the ambient outside environment do not enter the immediate internal wafer environment.

Control of particulate contamination is imperative for cost effective, high-yielding and profitable manufacturing of VLSI circuits. Because design rules increasingly call for smaller and smaller lines and spaces, it is necessary to exert greater and greater control on the number of particles and to remove particles with smaller and smaller diameters.

Some contamination particles cause process defects, such as incomplete etching in spaces between lines leading to an unwanted electrical bridge. In addition to such physical process defects, other contamination particles may cause electrical failure due to induced ionization or trapping centers in gate dielectrics or junctions.

Modern processing equipment must be concerned with particle sizes which range from below .01 micrometers to above 200 micrometers. Particles with these sizes can be very damaging in semiconductor processing. Typical semiconductor processes today employ geometries which are 1 micrometer and under. Unwanted contamination particles which have geometries measuring greater than 0.1 micrometer substantially interfere with 1 micrometer geometry semiconductor devices. The trend, of course, is to have smaller and smaller semiconductor processing geometries.

In typical processing environments today, "clean rooms" are established in which, through filtering and other techniques, attempts are made to remove particles having geometries of .03 micrometer and above. There is a need, however, to improve the processing environment. The conventional "clean room" cannot be maintained as particle free as desired. It is virtually impossible to maintain conventional clean rooms free of particles of a .01 micrometer size and below.

The main sources of particulate contamination are personnel, equipment, and chemicals. Particles given off by personnel are transmitted through the environment and through physical contact or migration onto the wafer surface. People, by shedding of skin flakes, for example, are a significant source of particles that are easily ionized and cause defects. Although clean room garments reduce particle emissions they do not fully contain the emissions. It has been found that as many as 6000 particles per minute are emitted into an adjacent one cubic foot of space by a fully suited operator.

To control contamination particles, the trend in the industry is to build more elaborate and expensive clean rooms with HEPA and ULPA recirculating air systems. Filter efficiencies of 99.999% and up to ten complete air exchanges per minute are required to obtain an acceptable level of cleanliness.

To minimize process defects, processing equipment manufacturers must prevent machine generated particles from reaching the wafers, and suppliers of gases and liquid chemicals must deliver cleaner products. Most important, a system must be designed that will effectively isolate wafers from particles during storage, transport and transfer into processing equipment. The Standard Mechanical Interface (SMIF) system has been proposed to achieve this goal. The SMIF concept is based on the realization that a small volume of still, particle-free air, with no internal source of particles, is the cleanest possible environment for wafers. Further details of one proposed system are described in the article "SMIF: A TECHNOLOGY FOR WAFER CASSETTE TRANSFER IN VLSI MANUFACTURING", by Mihir Parikh and Ulrich Kaempf, Solid State Technology, July 1984, pp. 111-115 and in the above cross-referenced applications.

The proposed SMIF system has three main components, namely, (1) minimum volume, dustproof containers are used for storing and transporting wafer cassettes; (2) canopies are placed over cassette ports of processing equipment so that the environments inside the containers and canopies become miniature clean spaces; (3) doors on the containers are designed to mate with doors on the interface ports on the equipment canopies and the two doors are opened simultaneously so that particles which may have been on the external door surfaces are trapped ("sandwiched") between the doors.

In the proposed SMIF system, a container is placed at the interface port on top of the canopy; latches release the container door and the canopy port door simultaneously. A mechanical elevator lowers the two doors, with the cassette riding on top, into the canopy covered space. A manipulator picks up the cassette and places it onto the cassette port/elevator or other location within the canopy of the equipment. After processing, the reverse operation takes place.

The SMIF system has been proved effective by experiments using prototype SMIF components both inside and outside a clean room. The SMIF configuration achieved a ten-fold improvement over the conventional handling of open cassettes inside the clean room.

However, due to the space limitations within the canopy of the processing station, the size and configuration of the elevators and manipulators is important. Furthermore it is desirable that the equipment for removing the cassette holding articles to be processed from the standard mechanical interface container be confined to a small space when not in use while providing a long reach to adjacent equipment.

The invention comprises an apparatus for transferring a cassette holding articles to be processed to and from a container supported at a processing station. The processing station includes a cassette port for receiving the cassette when the cassette moves along a central axis extending from outside the processing station through the cassette port and into the processing station. The apparatus includes an elevator including a platform transportable along the vertical axis. The platform is suitable for transferring the cassette to and from the container along the axis. The apparatus also includes a mechanical manipulator including an arm pivotably attached to a platform for engaging a cassette and for transferring the engaged cassette to a location offset from the vertical axis. Furthermore, the apparatus includes a device for translating the platform and arm linearly in a direction substantially perpendicular to the axis.

It will be appreciated that the apparatus of the present invention advantageously permits the automated placement of cassettes at positions displaced from the vertical axis at distances greater than the length of the pivotably attached arm.

Additional objects and features of the invention will appear from the following description in which the preferred embodiments of the invention have been set forth in detail in conjunction with the drawings.

FIG. 1 is a perspective view of the manipulator according to the present invention with a simplified depiction of a processing station.

FIGS. 2 through FIG. 6 are side view drawings of the manipulator according to the present invention used in description of the manipulation of a cassette holding articles to be processed from a SMIF container into the processing station.

FIG. 7 is a backview of the manipulator according to the present invention showing a means for transporting the platforms along the shaft.

FIG. 8 is a side view drawing of one embodiment of the manipulator according to the present invention having a manipulator arm with a movable pivot point on a carriage on the second platform.

FIG. 9 is a side-view drawing of an apparatus in accordance with the present invention showing a single arm and associated gear box in a first position and in a displaced second position.

FIG. 10. is an elevation view of the gripper of the apparatus of Fig. 9.

FIG. 11 is a top elevation view of the apparatus in Fig. 9 illustrating various positions and orientations in which a cassette can be placed by the apparatus.

FIG. 12 is a top elevation view of the apparatus of FIG. 9 illustrating various alternative positions and various alternative orientations in which a cassette may be placed by the apparatus.

With reference to the Figures, a detailed description of preferred embodiment for the present invention is described.

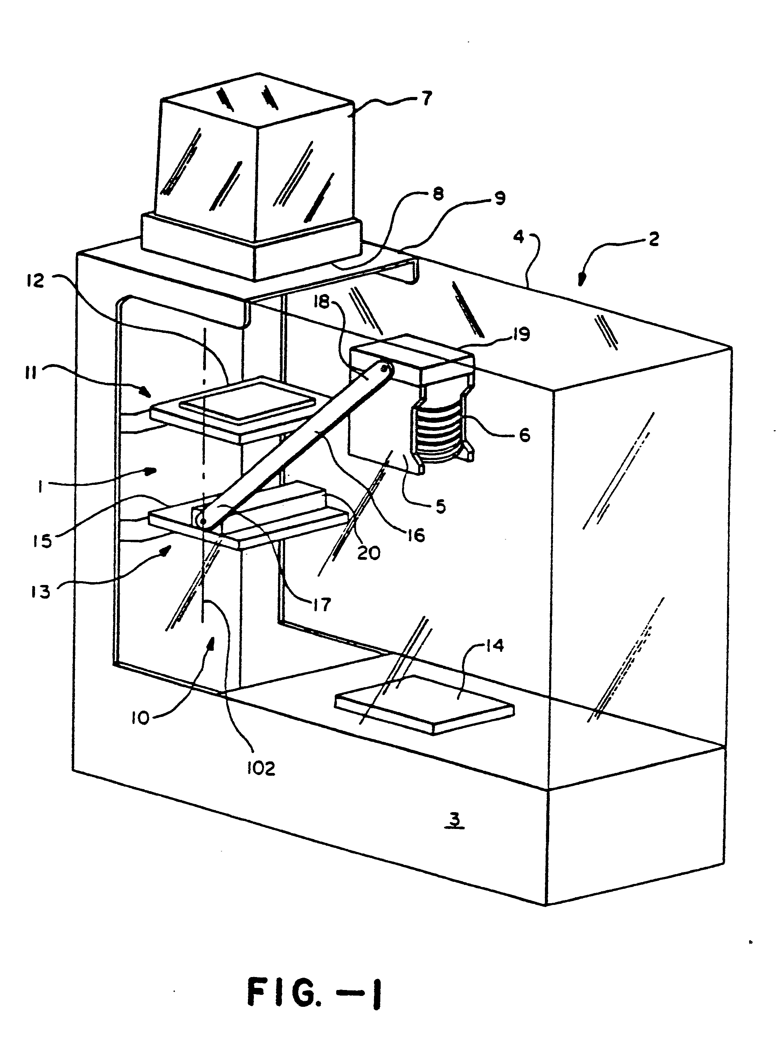

FIG. 1 shows a perspective view of the manipulator 1 of the present invention mounted with a simplified depiction of a processing station 2 with which the manipulator 1 is used. The processing station 2 includes a body 3 in which a processing step is conducted. For instance, when the articles to be processed are semiconductor wafers, the processing station may operate to place a layer of photoresist on the surface of the wafer. Of course, many other processing steps may be accomplished.

The processing station 2 includes a canopy 4 which covers the open parts of the body 3 of the processing station 2. The canopy 4 prevents particulate contamination inside the processing station 2. Manipulator 1 operates to remove a cassette 5 holding articles 6 to be processed from a container 7 through a cassette port 8 and transport the cassette 5 into the processing station 2. The cassette port 8 in preferred embodiment is described in detail in the prior application entitled BOX DOOR ACTUATED RETAINER referred to above and incorporated by reference as if fully set forth herein.

The manipulator 1 comprises a port plate 9 supporting the cassette port 8, and a shaft 10 including a central axis 102 extending from the cassette port 8 into the processing station 2. Alternatively, the cassette port 8 may be incorporated into the canopy 4 of the processing station 2. Preferably, the shaft 10 and central axis 102 extends vertically down from the cassette port 8 so that gravity operates to lower the cassette 5 from the container 7 when the cassette port 8 is open.

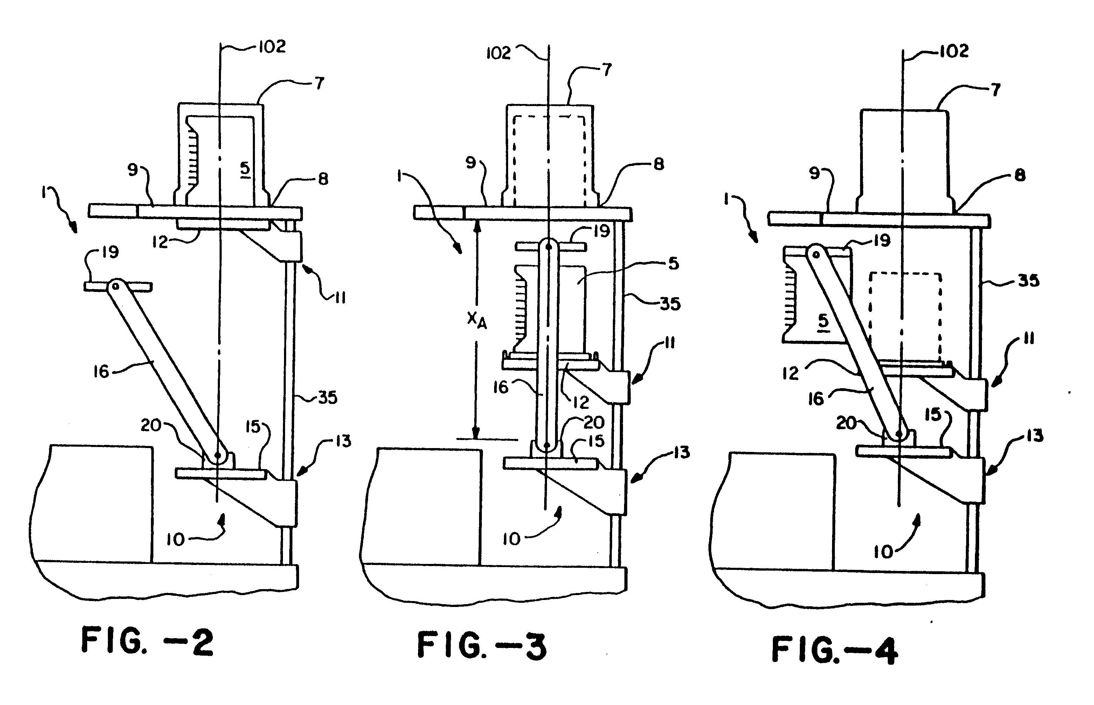

Further, the manipulator 1 includes a first means 11 for supporting the cassette 5 and transporting the cassette 5 along the central axis of shaft 10 through the cassette port 8 to and from the processing station 2. The first means 11 includes a first platform 12 that is supported in the shaft 10. The cassette 5 is supportable on the first platform 12 so that when the cassette port 8 is opened, the cassette 5 rests on the first platform 12. An alignment pin (not shown) may be mounted on the first platform 12 to support the cassette 5 or other means for holding the cassette 5 on the platform 12 may be used. As described in more detail with reference to FIG. 2 through FIG. 6, the first means includes a means for controllably moving the first platform 12 with the cassette supportable thereon through the shaft 10 from adjacent the port 8 to and from any position along the central axis 102 of the shaft 10. Thus the first platform 12 is moveable up the shaft to mate with and seal the cassette port 8. When the cassette port 8 opens, the cassette 5 is supported on the first platform 12. The first platform 12 may then be lowered along the shaft 10 into the processing station 2 with the cassette 5 riding on it.

The manipulator 1 further includes a second means 13 that is transportable through the shaft 10 for transporting the cassette 5 to and from at least one location 14 away from the shaft 10 inside the processing station 2 and for transporting the cassette 5 to and from the first means 11 when the first means 11 is away form the cassette port 8.

The second means 13 includes a second platform 15 supported in the shaft 10. Further, a mechanical arm 16 is pivotally mounted on the second platform 15. The mechanical arm 16 includes a first end 17 and a second end 18. First end 17 is mounted pivotally on the second platform 15 and operable to pivot about the first end 17 in a plane orthogonal to the shaft 10.

Mounted on the second end 18 of the mechanical arm 16 is an engaging means 19 for engaging the cassette 5 holding articles 6 to be processed. The engaging means 15 is preferably pivotally mounted on the second end 18 of the mechanical arm 16 and includes a means for maintaining the cassette 5 upright, such as a bearing allowing gravity to vertically align the cassette 5 while engaged on the engaging means 19.

The second means 13 further includes a means for controllably moving the second platform 15 through the shaft 10. Also included is a means 20 for controlling the position of the second end 18 of the mechanical arm 16, such as a stepper motor or belt driven gear box mounted on the second platform 15. The means 20 for controlling the position of the second end 18 of the mechanical arm 16 operates in conjunction with engaging means 19 so that the cassette 5 is supported for transporting along the plane orthogonal to the central axis 102 of shaft 10 to and from the at least one location 14 within the processing station 2 and to and from the first means 11.

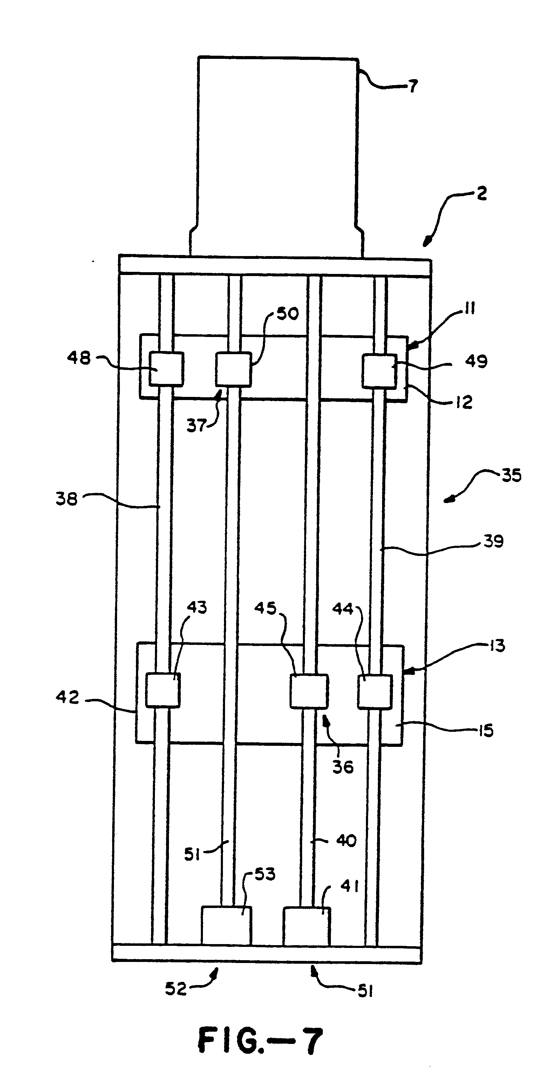

Further details of the preferred embodiment of the manipulator 1 according to the present invention is described with reference to FIG. 2 through FIG. 6, which show various positions of the manipulator 1 as it transports a cassette 5 from within the container 7 to a location 14 shown in FIG. 5 and 6. The parts of the manipulator 1 shown in FIG. 2 through 6 are labelled with reference numbers consistent with the view shown in FIG. 1 where appropriate.

FIG. 2 shows the manipulator 1 in a position for removing the cassette 5 from the container 7. The cassette 5 remains inside the container 7 on the processing station 2. The first platform 12 of the first means 11 is positioned adjacent the cassette port 8 on the port plate 9. The second means 13 is positioned low in the shaft 10 allowing a large range of freedom of movement in the shaft 10 by the first means 11.

When the cassette port 8 releases the cassette 5, the first platform 12 is lowered into the shaft 10 as shown in FIG. 3. The second platform 15 of the second means 13 is raised slightly and the mechanical arm 16 is positioned using the stepper motor 20 so that the engaging means 19 is aligned over the cassette 5 while it is supported on the first platform 12.

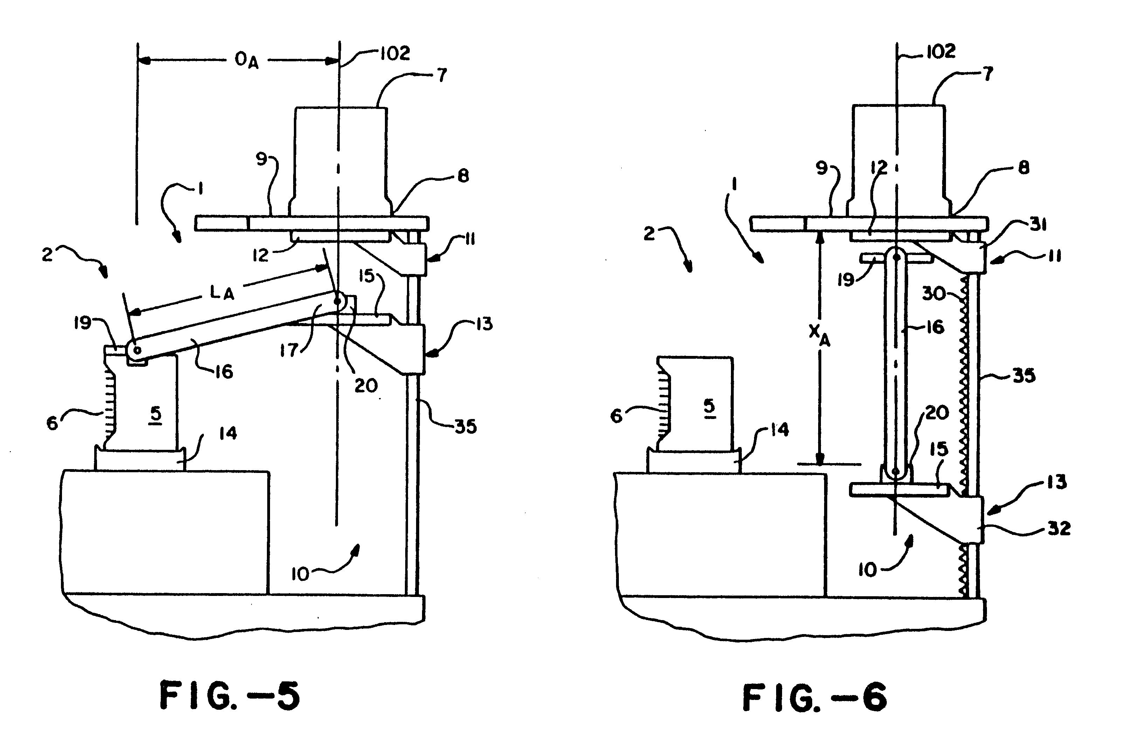

The second means 13 is then lowered allowing the engaging means 19 to engage the cassette 5. Then it is raised as shown in FIG. 4 lifting the cassette 5 off of the first platform 12 while the mechanical arm 6 pivots and swings the cassette 5 along a plane orthogonal to the central axis 102 of shaft 10 out of the shaft 10. This allows the first means 11 to move along the shaft above the second means 13 so that the container 7 on the cassette port 8 may be closed by the first platform 12 of the first means 11.

As shown in FIG. 5, the first platform 12 is positioned adjacent the cassette port 8 sealing the container 7. The second platform 16 supporting the stepper motor 20 and the first end 17 of the mechanical arm is positioned along the shaft 10 as the mechanical arm 6 swings along the plane orthogonal to the shaft 10 to position the cassette at a location 14 inside the processing station 2. The position 14 is, at a maximum, offset from central axis 102 by a displacement, $O_A$, which is equal to the arm length, $L_A$.

As shown in FIG. 6, the second means 13 operates to lower the second platform 15 into the shaft 10 while the mechanical arm 16 is swung in alignment with the central axis 102 of shaft 10 below the first platform 12. In this manner, the mechanical arm 6 is positioned compactly in the shaft 10 with a clearance distance, $X_A$, which permits the coaxial loading and unloading of cassette 5 into and out from container 7 (see also FIG. 3). Cassette 5 moves and avoids interference with any manipulation that may occur in the processing station 2.

As can be seen, the manipulator 1 is operable to transport the cassette 5 to and from the first platform 12 of the first means 11 and while the cassette 5 is on the first platform 12, the manipulator 1 is operable to transport the cassette 5 to and from the container 7 mounted on a cassette port 8. These functions are accomplished in a minimum amount of space inside the processing station 2.

FIG. 6 schematically shows a particle shield 30 which is mounted along the shaft 10 isolating the mechanics in the means for transporting the first platform 12 and the second platform 15 along the shaft. The isolating shield 30 may be manufactured of an accordion-like folding plastic, such as mylar or other material, so that as the first means 11 and the second means 13 are transported along the shaft 10, the isolating shield 30 remains intact. Of course, other means for isolating the mechanics of the means for moving the first platform 12 and the second platform 15 may be utilized as suits the user.

The control signals operating the mechanical arm 16, the engaging means 19, the cassette port 8 and means for holding the cassette 5 on the first platform 12 are all transmitted through or along the support 31 in the first means 11 and the support 32 in the second means 13 to a control, such as a computer or other signal processing device (not shown).

As can be seen in FIGS. 2 through 6, the first means 11 and the second means 13 are supported on a guide means 35 mounted in the shaft 10. FIG. 7 shows a back view of the guide means 35 on which the first means 11 and the second means 13 are mounted.

The guide means 35 includes a means 36 for controlling the position of the second platform 15 in the shaft 10 and a means 37 for controlling the position of the first platform 12 in the shaft 10. The means 36 comprises a worm gear apparatus 51 made up of a threaded bar 40 and a motor 41 for controllably rotating the threaded bar 40. Also, a means for supporting the second means 13, such as bearings 43, 44, on a first guide 38 and a second guide 39 are included. The second means 13 also includes a gear bearing 45 which mates with the threaded shaft 40 so that as the threaded shaft 40 is rotated by the motor 41, the position of the second means 13 in the shaft is controlled.

The means 37 for controlling the position of the first platform 12 in the shaft 10 is of a similar construction as the means 36. Thus, a bearing 48 and a bearing 49 are mounted with the first means 11 for supporting the first means 11 in alignment with the first guide 38 and the second guide 39, respectively. A gear bearing 50 is mounted on the first means 11 which mates with the threaded shaft 51 of the worm gear apparatus 52 which operates to control the moving of the first means 11 along the shaft 10. The threaded shaft 51 is rotated controllably by a motor 53 for controllably positioning the first means 11.

The bearings 48 and 49 for maintaining alignment of the first means 11 and the bearings 33 and 34 for maintaining alignment of the second means 13 must provide stable positioning of the first means 11 and the second means 13. Thus, the bearings may be altered to provide a three point support system (not shown) or the guides 38 and 39 and the bearings mating with the guides 38 and 39 should otherwise provide lateral support.

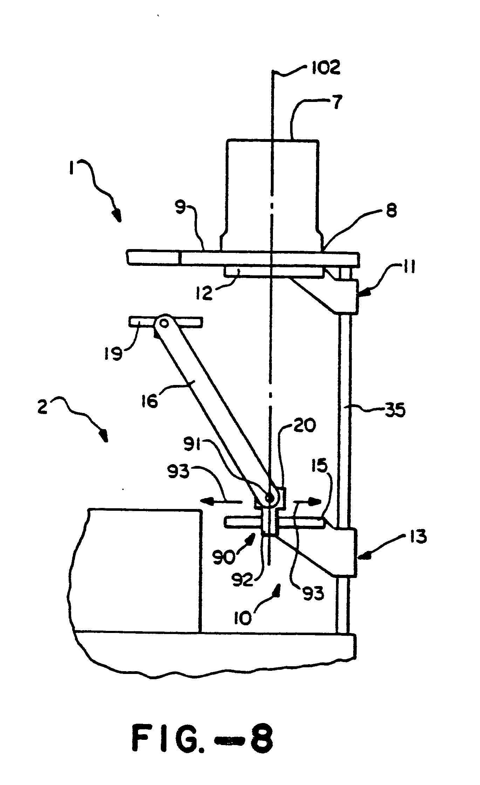

FIG. 8 shows the side view of the manipulator 1 according to an alternate embodiment of the present invention. In particular, the means 20 for controlling the position of the second end 19 of the manipulator arm 16 further includes a carriage and rail assembly 90 on the second platform 15. The pivot point 91 on the first end of the manipulator arm 16 is mounted on the stepper motor or gear box as described above. The stepper motor or gear box is in turn mounted on a carriage 92 on the second platform 15. The second platform 15 includes a rail 93 which guides the carriage 92 along an axis defining a direction 93 orthogonal to the shaft 10. The carriage and rail assembly 90 provides means for positioning the pivoting point 91 of the manipulator arm 16 to provide further flexibility in positioning a cassette mounted on the engaging means 19 within the processing station 2. The carriage position is controlled by a motor or belt driven apparatus such as are well known in the art (not shown).

In summary, disclosed is a manipulator for removing a cassette holding articles, such as semiconductor wafers, to be processed from a container into a processing station in a standard mechanical interface (SMIF) system. The container is supported on a cassette port on the manipulator of the processing station. A first platform is transportable along a shaft below the cassette port and is operable to mate with the cassette port and receive the cassette from the container. The first platform is transported down the shaft, thereby removing the cassette from the container. A second platform mounted in the shaft includes a manipulator arm which swings to engage the cassette on the first platform and support the cassette off of the first platform. The manipulator arm then pivots to transport the cassette to a location in the processing station away from the shaft. The first platform is then transported back up the shaft to the cassette port to seal the container to prevent particulate contamination. The manipulator arm and the second platform after placing the cassette at a location in the processing station away from the shaft, are then positionable completely inside the shaft to minimize the space taken up in the processing station by the manipulator.

Referring now to the drawings of Fig. 9, there is shown a presently preferred embodiment of a long arm manipulator with axial drive (hereinafter, "manipulator with drive__ 200. Like the manipulator 1 illustrated in Figs. 1-8, the manipulator with drive 200 includes a clean region 202 within which a casssette 204 bearing seminconductor wafers 206 can be manipulated. Furthermore, the manipulator with drive 200 includes a gear mechanism 208 for causing the rotation of a respective arm 210. The gear mechanism 208 is mounted on an linear drive mechanism 212 adapted for translating the gear mechanism 208 and the arm 210 in a horizontal direction. A gripper 214 for gripping cassettes is rotatably attached near the end of the arm 210 distal from the gear mechanism 208.

The arm 210, gripper 214, gear mechanism 208 and linear drive 212 all are disposed within a manipulator container 216 which defines the clean region 202. The container 216, in turn, is mounted on verticle support structures 218-1 and 218-2 used to regulate the height of the liner drive mechanism 212 and its associated arm 210, gear mechanism 208 and gripper 214 relative to processing equipment 221, here a Varian 350-D, with which the manipulator with linear drive 200 is used.

In operation a SMIF container (not shown) is placed in communication with a port plate 220 of the mechanism with linear drive 200. A cassette 204 is introduced to the clean region within the manipulator container 216 by means of an elevator 222 which lowers the cassette 204 into the manipulator container 216. Details of the opening of the port plate 220 and the lowering of the cassette 204 using the elevator 222 are omitted at this point because they will be understood from the discussion above with reference to Figs. 1-8. It should be noted, however, that unlike the manipulator 1 discussed with reference to Figs. 1-8, neither the arm 210 nor the gear mechanism 208 move vertically relative to the rest of the components of the manipulator with drive 200.

The elevator 222 lowers the cassette to a position where the gripper 214 can be brought into contact with the cassette 204 so as to grip the cassette 204. The cassette 204 can be gripped in one of two ways: face grip or top grip.

The gripper 214 shown in Fig. 9 at the left is shown in a position to grip a cassette 204 using a face grip. Basically, a face grip involves gripping the cassette from the side.

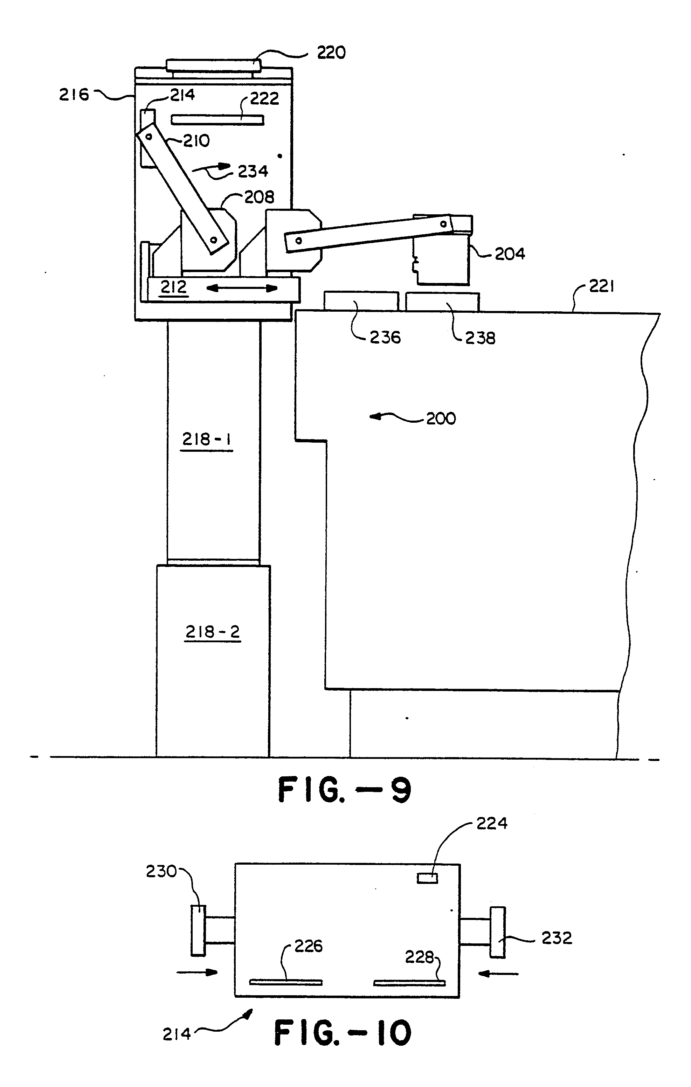

Fig. 10 provides a front elevation view showing details of the face of a gripper 214 used to make a face grip. In operation, the arm 210 is rotated so as to bring the face of the gripper 214 into contact with a cassette 214. The face of the gripper includes two switches to sense when the gripper 214 is in close enough proximity to a cassette 204 to grip it. A first switch has a single actuator 224 for sensing a top portion of the side of the cassette. A second switch includes two segments of the actuator bars 226 and 228. The second switch is triggered only when both two segments of the actuator bar 226 and 228 are depressed. The left and right side clamps 230 and 232 move inwardly in the direction of the arrows when both the first and second switches are triggered. The two segment actuator bar 226 and 228 of the second switch ensure that the side clamps 230, 232 do not move inwardly and attempt to clamp the cassette 204 unless the cassette 204 is properly aligned relative to the gripper 214.

Once the cassette 204 has been gripped, the elevator 222 is moved downward to move it away from the cassette 204 which is now supported by the gripper 214. The arm 210 plus the gripper 214 and the cassette 204 are rotated in the clockwise direction shown by the arrow 234. Simultaneously, the gripper 214 rotates counter-clockwise relative to the arm 210 such that the cassette 204 rotates 90° relative to its starting postion.

The elvator 222 is moved back upwards. If the cassette is to be placed in position 236 on the processing equipment 221 then the arm 210 is caused to genetly place the cassette 204 in position 236; the gripper then releases the cassette 204. If, however, the cassette 204 is to be placed in position labelled 238 then the linear drive mechanism 212 causes the entire gear mechanism 208 and the arm 210, gripper 214 and cassete 204 to translate linearly to the right so that the cassette is aligned with position 238. The arm 210 then genetly moves the cassette 204 into position 238, and the gripper releases the cassette. The arm 210 rotates counter-clockwise to a point to celar any obstructions. The linear drive mechanism 212 moves the gear mechanism 208, arm 210 and gripper 214 back to the starting position to the left.

After the deposit of the cassette 204 at the position 236 or the linear translation of the gear mechanism 208, arm 210, gripper 214 and cassette 204 back into the starting position, the arm 210 rotates counterclockwise to its starting position; and the gripper rotates clockwise relative to the arm 210 back to its starting position.

Alternatively a different gripper 214 can be used which grips the cassette 204 from the top. This gripper does not rotate the cassette 204 relative to its starting position. Although the gripper 214 may tilt the cassette 204 momentarily so as to cause the wafers to slide into a proper seating position with the cassette. Rather, the cassette 204 remains level. The discussions and drawings of Figs. 1-8 illustrate the use of this type of gripper 214.

The linear drive mechanism 212 and the gear mechanism 208 can be configured to place the cassete 204 in either of two positions directly to the right or directly to the left of the manipulator with drive 200 or in either of two positions in front and to the left of the mechanism with the drive 200 or in front and to the right.

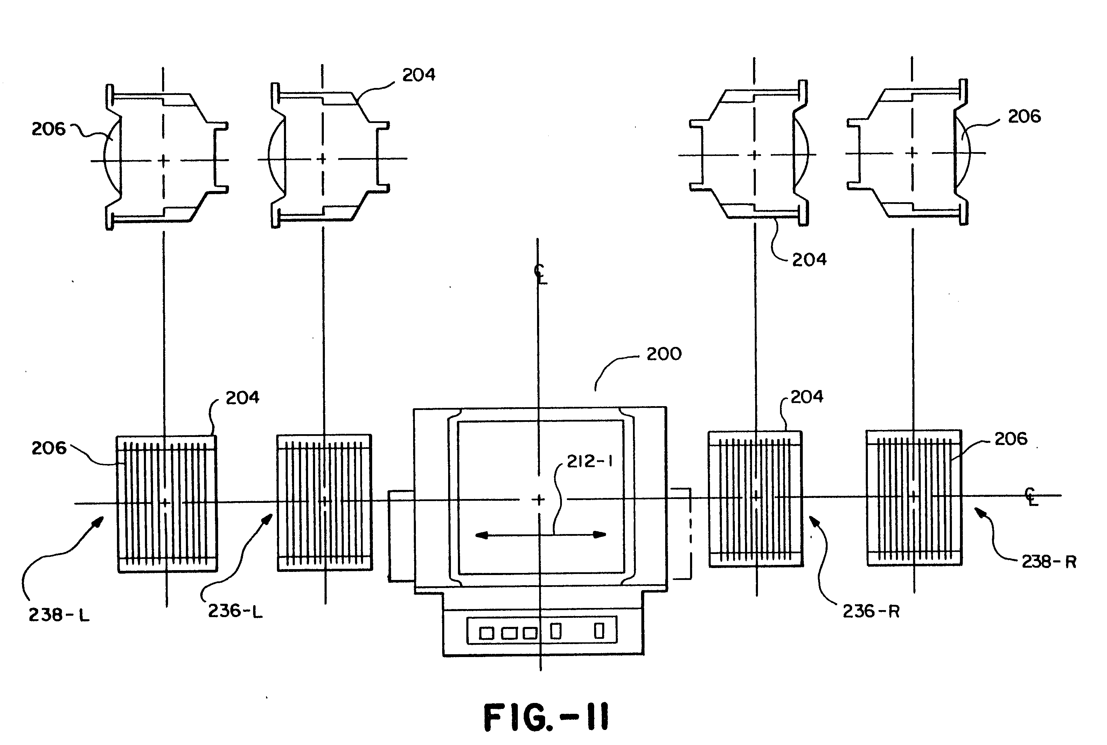

More particularly, Fig. 11 shows a top elevation view of the mechanism with drive 200. Arrow 212-1 shows the direction of linear translation of the gear mechanism 208, arm 210, gripper 214 and cassette 204. It can move either to the left and back or to the right and back. When it is configured to move left, a cassette 204 can be placed in either location 236-L or 238-L when it is configured to move right, a cassette 204 can be placed in either location 236-R or 238-R.

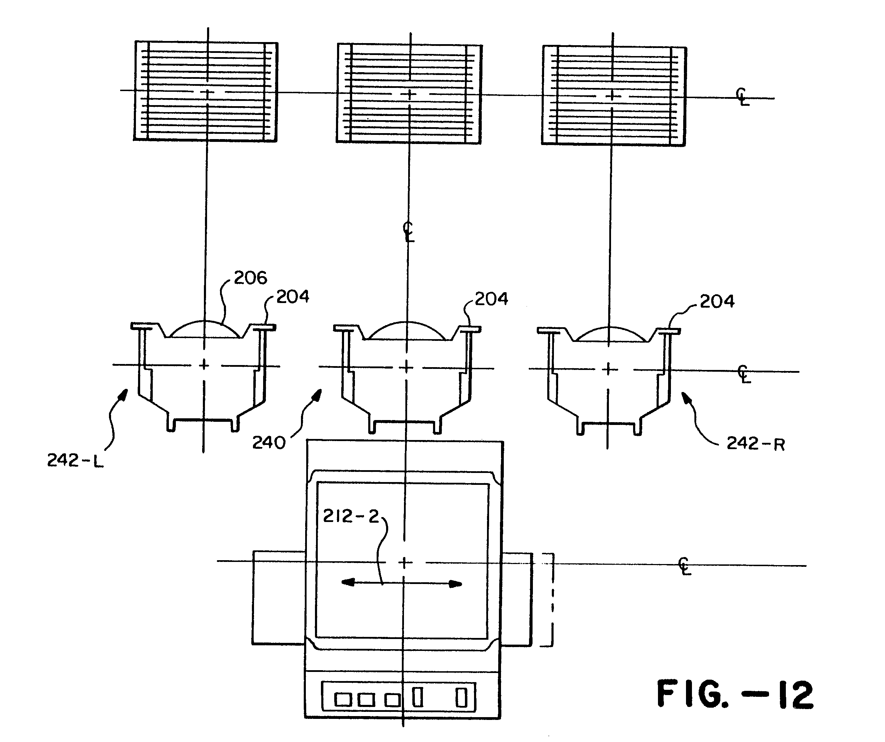

Fig. 12 is a top elevation view of the mechanism with drive 200. Arrow 212-2 shows the direction of linear translation of the gear mechanism 208, arm 210, gripper 214 and cassette 204. Once again, it can move to the left and back or to the right back along a path indicated by arrow 212-2. In Fig. 12, however, the gear mechanism 208 and the arm 210 and gripper 214 have been rotated 90° relative to the drive mechanism 212 as it appears in Fig. 9. Consequently, when the drive 212 is caused to remain in the home or starting position the cassette 204 is placed in position 240 when the arm 210 is rotated. If the gear mechanism 208, arm 210, gripper 214 and cassette 204 is linearly translated to the right then the cassette 204 can be placed in position 242-R. If the gear mechanism 208 arm 210, gripper 214 and cassette 204 is linearly translated to the left then the cassette 204 can be placed in position 242-L.

The foregoing description of a preferred embodiment of the invention has been presented for the purposes of illustration and description. It is not intended to be exhaustive or to limit the invention to the precise form disclosed, and obviously many modifications and variations are possible in light of the above teachings. Thus, further aspects of the invention can be determined by a study of the specification, the drawings and the claims. It is intended that the scope of the invention be defined by the claims appended hereto.

While the invention has been particularly shown and described with reference to preferred embodiments thereof, it will be understood by those skilled in the art that the foregoing and other changes in form and detail may be made therein without departing from the spirit and scope of the invention.

## Claims

1. An apparatus for transferring a cassette holding articles to be processed to and from a container supported at a processing station where the processing station has a cassette port for receiving the cassette when the cassette moves along a central axis extending from outside the processing station through the cassette port, and into the processing station, said apparatus comprising:

cassette platform means including a cassette platform transportable along said vertical axis for transferring the cassette to and from the container along said axis;

manipulator means including an arm pivotably attached to a platform for engaging a cassette and for transferring the cassette to a location offset from said axis; and

means for linear translation of said platform and arm in a direction substantially perpendicular to said axis.

2. The apparatus of Claim 1 wherein said means for linear translation is adapted to move said platform and arm in either of two substantially parallel and opposite directions substantially perpendicular to said axis.

3. The apparatus of Claim 1 wherein said manipulator means is adapted for causing said arm to rotate in a plane substantially parallel to the axis.

4. The apparatus of Claim 1 wherein said arm further includes means for gripping the cassette, said means for gripping including means for detecting whether the cassette is positioned for being gripped by said means for gripping.

# FIG. —1

FIG. -2

FIG. -3

FIG. -4

FIG. -5

FIG. -6

0 292 235

FIG.—7

0 292 235

FIG. —8

FIG. - 9

FIG. - 10

FIG.-II

FIG. —12